# EUROPEAN PATENT SPECIFICATION

(11) **EP 2 439 517 B1**
(45) Date of publication and mention of the grant of the patent: **29.04.2015**
(21) Application number: 11182130.2
(22) Date of filing: 21.09.2011
(51) Int. Cl.: G01N 21/956, G01N 21/95, G01R 31/26

(54) **Detection method and detection device for wafer level led chips and transparent probe card thereof**
Detektionsverfahren und Detektionsvorrichtung für LED-Chips auf Waferebene und transparente Nadelkarte dafür
Procédé et dispositif de détection pour puces DEL de niveau de tranche et carte de sonde transparente correspondante

(30) Priority: 11.10.2010 TW 99134642
(43) Date of publication of application: 11.04.2012
(73) Proprietor: Industrial Technology Research Institute, Chutung Hsinchu 31040 (TW)
(72) Inventor: Lin, Jian-Shian, Yilan County 26066 (TW); Lin, Hung-Yi, Hsinchu City 300 (TW); Peng, Yao-Chi, Hsinchu City 30052 (TW); Cheng, Chia-Shen, Taichung City 40247 (TW)
(74) Representative: Von Kreisler Selting Werner - Partnerschaft von Patentanwälten und Rechtsanwälten mbB

(56) References cited:
- DE-A1- 19 717 369
- US-A1- 2006 226 848
- US-A1- 2007 170 933
- US-A1- 2010 244 055

## Description

This application claims the benefit of Taiwan application Serial No. 99134642, filed October 11, 2010, the subject matter of which is incorporated herein by reference.

### BACKGROUND

### Technical Field

The disclosure relates in general to a chip detection method, a detection device and a probe card thereof, and more particularly to a detection method and a detection device for wafer level light emitting diode (LED) chips, and a transparent probe card thereof.

### Description of the Related Art

The conventional detection method for test of the luminescent properties of the LED chips on the wafer one by one is performed with a point testing device. Suppose there are 2000 LED chips on a 5,08 cm (2-inch) wafer, the testing time is tedious and efficiency is poor when the LED chips are tested one by one by the point testing method.

Examples of the conventional point testing device include the point testing structure disclosed in the Taiwanese Patent Publication No. M382577 "Point Testing Device" and the Taiwanese Patent Publication No. M260860 "Structure Using Cut Die Point Testing System". The said point testing device performs test on single LED chip. However, the system for testing the electric and luminescent properties of the single LED chip is slow and incurs high cost, and does not meet the market requirements of fast and simple testing system. To further increase the detection rate and quality, how to provide automatic detection method and the detection device for LED chips for analyzing the spectrums, luminous intensities and luminescent properties of the LED chips so as to perform classification promptly has become an essential technology to the industries.

DE 19717369 A1 to which the preambles of each of independent claims 1 and 4 refer discloses a testing device for measuring electrical properties of a plurality of chips on a semiconductor wafer.

US 2007/0170933 A1 discloses a method and apparatus for non-destructively evaluating light-emitting materials. An electrode probe is used to temporarily form a light-emitting device through forming an intimate electrical contact to the surface of the light-emitting material.

### SUMMARY

The subject matter of the invention is defined by each of independent claims 1 and 4.

The disclosure is directed to a detection method and a detection device for wafer level LED chips and a transparent probe card thereof. The detection method and detection device of the disclosure have the advantages of quick detection and classification. The present disclosure resolves the efficiency problem occurring to the conventional point testing device, which can only detect one single LED chip at a time and is unable to increase the efficiency.

According to a first aspect of the present disclosure, a detection method for wafer level LED chips is provided. The method is used in a wafer and the wafer includes a base substrate and a plurality of LED chips disposed on a base substrate, wherein each of the LED chips includes at least a testing pad. The detection method includes the following steps. A transparent probe card including a plurality of contacts is provided, wherein the contacts correspond to the testing pads. The transparent probe card covers the wafer for electrically connecting the testing pad via the contacts of the transparent probe card so as to perform a light-up test on the LED chips. When the LED chips are lighted up, an imaging process is performed on the light signals of the LED chips to form an image on a sensing element. The image is captured, and the image is converted into an optical field information and a position information corresponding to each of the LED chips. The spectrum and luminous intensity of each of the LED chips are obtained according to the optical field information of each of the LED chips. The LED chips are classified according to the spectrum and/or luminous intensity of each of the LED chips.

According to a second aspect of the present disclosure, a detection device for wafer level LED chips is provided. The device is used in a wafer and the wafer includes a base substrate and a plurality of LED chips disposed on a base substrate, wherein each of the LED chips includes at least a testing pad. The detection device includes a transparent probe card, an imaging module, an image processing module, an analysis module and a classification module. The transparent probe card includes a plurality of contacts respectively corresponding to the testing pads. The transparent probe card covers the wafer for electrically connecting the testing pad via the contacts of the transparent probe cards so as to perform a light-up test on the LED chips. The imaging module is used for collecting light signals after lighting up the LED chips to form an image. The image processing module is used for capturing the image and converting the image into an optical field information and a position information corresponding to each of the LED chips. The analysis module is coupled to the image processing module and obtains the spectrum and luminous intensity of each of the LED chips according to each of the optical field information of the LED chips and position information. The classification module couples the analysis module and the image processing module to obtain the position information of each of the LED chips and further classify the LED chips according to the spectrum and/or luminous intensity of each of the LED.

According to a third aspect of the present disclosure, a transparent probe card used in a wafer is provided. The wafer includes a base substrate and a plurality of LED chips disposed on a base substrate, wherein each of the LED chips includes a plurality of first testing pads and a plurality of second testing pas. The transparent probe card includes a transparent substrate, a plurality of first transparent conductive wires and a plurality of second transparent conductive wires. The first transparent conductive wires are disposed on the transparent substrate, wherein each of the first transparent conductive wires includes a plurality of first contacts whose positions corresponding to that of the first testing pads. The second transparent conductive wires, disposed on the transparent substrate, are intersected and electrically isolated with the first transparent conductive wires, wherein each of the second transparent conductive wires includes a plurality of second contacts whose positions corresponding to that of the second testing pads.

The above and other aspects of the disclosure will become better understood with regard to the following detailed description of the non-limiting embodiment(s). The following description is made with reference to the accompanying drawings.

### BRIEF DESCRIPTION OF THE DRAWINGS

FIG. 1 shows a flowchart of a detection method for wafer level LED chips according to an embodiment of the disclosure.

FIG. 2 shows a detection device for wafer level LED chips according to an embodiment of the disclosure.

FIG. 3A shows a top view of a transparent probe card according to an embodiment of the disclosure.

FIG. 3B shows a top view of LED chips disposed on a base substrate

FIG. 3C shows a top view of a transparent probe card disposed on a wafer and a partial enlargement of region A;

FIG. 4 shows a flowchart of light filtering process according to a preferred embodiment of the disclosure; and

FIG. 5 shows an image processing module according to an embodiment of the disclosure.

### DETAILED DESCRIPTION

A detection method and detection device for wafer level LED chips and a transparent probe card thereof disclosed in an embodiment of the disclosure mainly perform electric property analysis and light-up test on the LED chips disposed on a base substrate. According to the detection method and device of the embodiment of the disclosure, a transparent probe card combined with an image processing module are used as an electrical detection unit and an optical detection unit for the LED chips, and the LED chips are classified according to the obtained information of spectrums and luminous intensities.

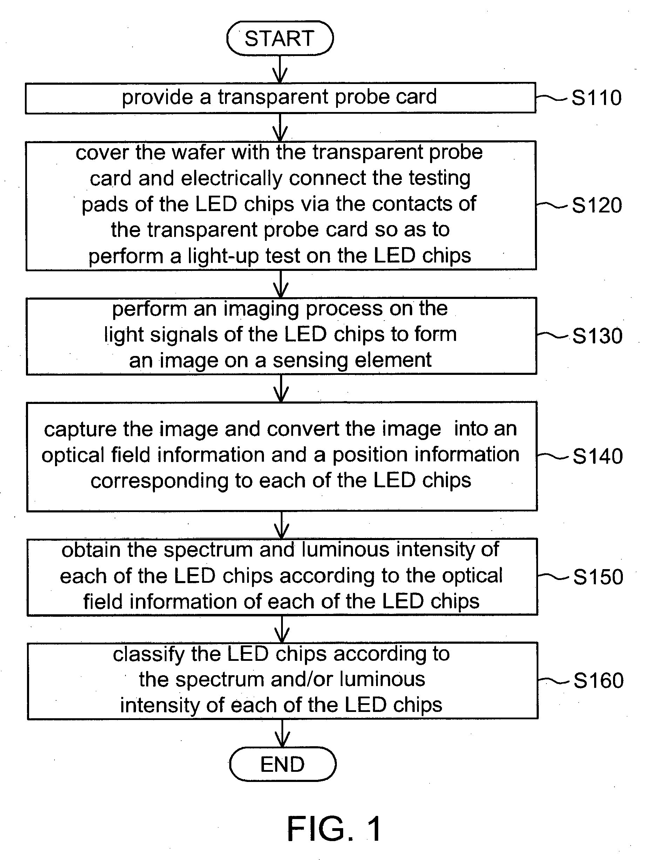

Referring to FIG. 1, a flowchart of a detection method for wafer level LED chips according to an embodiment of the disclosure is shown. The detection method includes steps S110~S160. In step S110, a transparent probe card is provided. In step S120, a wafer is covered with the transparent probe card, and the testing pads of each of the LED chips are electrically connected via the contacts of the transparent probe card so as to perform a light-up test on the LED chips. In step S130, an imaging process is performed on the light signals of the LED chips to form an image on a sensing element. In step S140, the image is captured, and the image signal is converted into an optical field information and a position information corresponding to each of the LED chips. In step S150, the spectrum and luminous intensity of each of the LED chips are obtained according to the optical field information of each of the LED chips. In step S160, the LED chips are classified according to the spectrum and/or luminous intensity of each of the LED chips.

Moreover, prior to step S140 of capturing the image, the detection method includes a step (not illustrated the diagram) of performing a light filtering process. Preferably, the step of the light filtering process is performed after step S130 of the imaging process, but the disclosure is not limited thereto. The step of the filtering process can also be performed before step S130 of the imaging process.

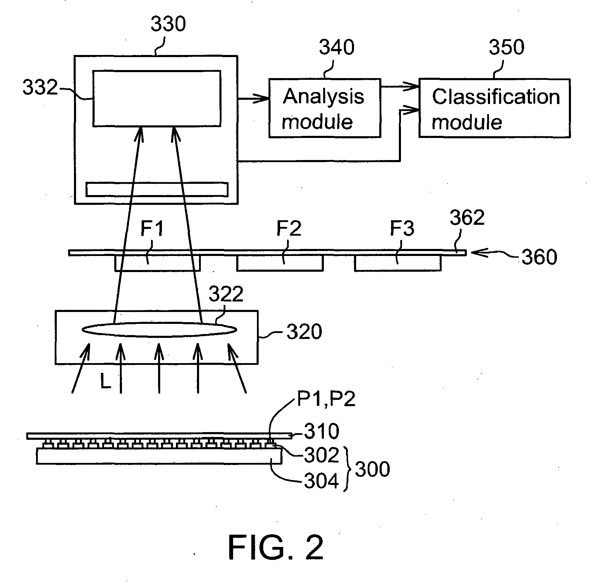

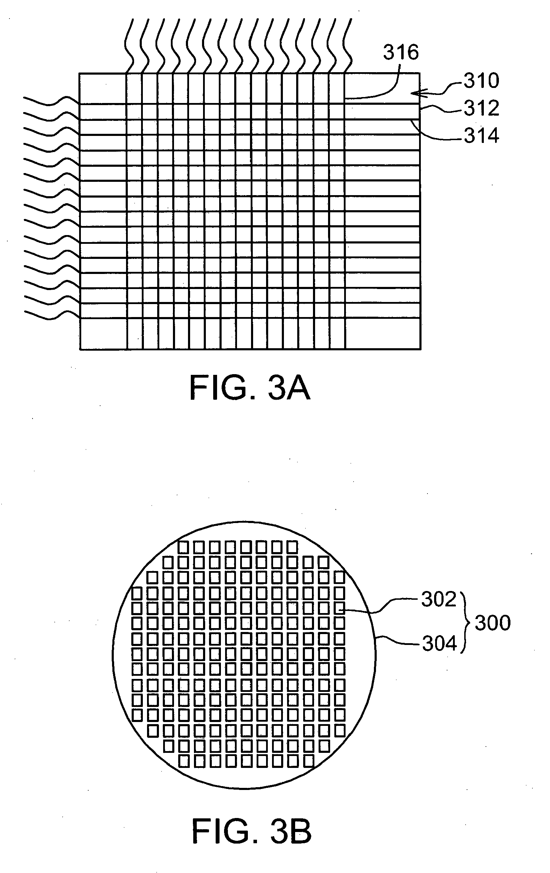

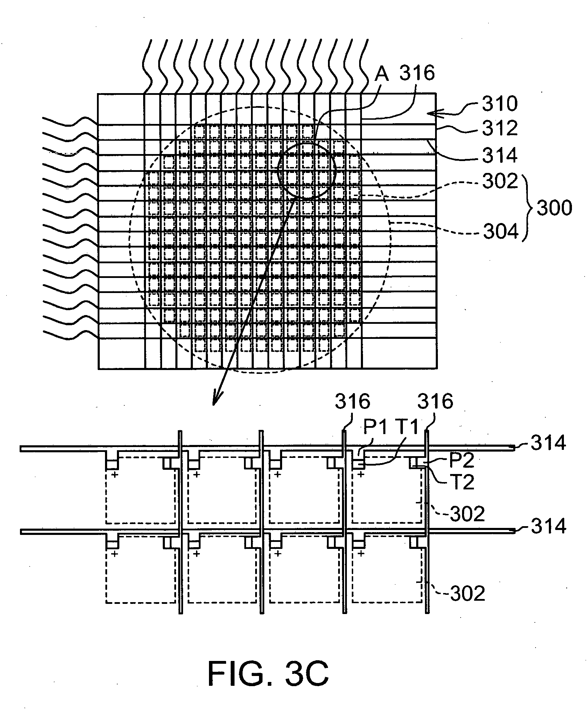

Referring to FIG. 2, a detection device for wafer level LED chips according to an embodiment of the disclosure is shown. The detection device includes a transparent probe card 310 (referring to FIG. 3A), an imaging module 320, an image processing module 330, an analysis module 340 and a classification module 350. The transparent probe card 310 covers the wafer 300, and the electrical testing contacts P1 and P2 (illustrated in FIG. 3C) of the transparent probe card 310 provide power to each of the LED chips 302 disposed on the base substrate 304 so as to perform a light-up test on the LED chips 302.

Moreover, the imaging module 320 can be realized by an imaging module 320 composed of a lens 322 or a plurality of lenses 322 for collecting the light signals L and imaging on the image processing module 330, so that the light signals L becomes a recognizable image, such as a spot diagram, wherein the light signal L is formed when the LED chips 302 are lighted up. The position (that is, the position information) of the light spot displayed on the spot diagram denotes the actual position of each of the LED chips 302 disposed on the base substrate 304. The light spots at different positions contain the information (that is, the optical field information) of the spectrums and the luminous intensities of the LED chips 302 disposed on different positions.

The image processing module 330 includes an array type charge coupled device (CCD) with high light sensitivity or a sensing element 332 with high resolution level such as a complementary metal oxide semiconductor (CMOS). The image processing module 330 is used for capturing the image, converting the image into an optical field information and a position information corresponding to each of the LED chips 302, and further outputting the optical field information and the corresponding position information to the analysis module 340.

The analysis module 340 is used for analyzing the optical field information and the corresponding position information of the LED chips. The analysis module 340 analyzes the optical field information of each of the LED chips 302 to trace back the spectrum and the luminous intensity of each of the LED chips 302 by the neural image analysis technology.

The classification module 350 is coupled to the analysis module 340 and the image processing module 330 to obtain the position information of each of the LED chips 302 and perform classification according to the spectrum and the luminous intensity of each of the LED chips 302. In an embodiment, the classification module 350 includes a display unit (not illustrated) for displaying the positions, distribution, eye-catching colors or marks of the LED chips 302 of different categories which can be used as a basis for classification.

Moreover, the detection device further includes a filter module 360 used for filtering the light signals L, which is disposed on the imaging path of the light signals L. In an embodiment, the filter module 360 is disposed between the imaging module 320 and the image processing module 330, but the disclosure is not limited thereto, and the filter module 360 can also be disposed between the wafer 300 and the imaging module 320.

Referring to FIGS. 3A, 3B and 3C. FIG. 3A shows a top view of a transparent probe card according to an embodiment of the disclosure. FIG. 3B shows a top view of LED chips disposed on a base substrate. FIG. 3C shows a top view of a transparent probe card disposed on a wafer and a partial enlargement of region A. The transparent probe card 310 includes a transparent substrate 312, a plurality of first transparent conductive wires 314 and a plurality of second transparent conductive wires 316. The transparent substrate 312, made from such as glass, covers the wafer 300. The first and the second transparent conductive wires 314 and 316, made from such as indium tin oxide (ITO), are formed on the transparent substrate 312, and the first transparent conductive wires 314 are intersected and electrically isolated with the second transparent conductive wires 316. As indicated in the partial enlargement of FIG. 3C, each of the first transparent conductive wires 314 includes a plurality of first contacts P1 (such as conductive bumps) whose positions respectively corresponding to that of the first testing pads T1 of the LED chips 302. In addition, a plurality of second transparent conductive wires 316 are respectively intersected with the first transparent conductive wires 314, and each of the second transparent conductive wires 316 includes a plurality of second contacts P2 (such as conductive bumps) whose positions respectively corresponding to that of the second testing pads T2 of the LED chips 302.

In addition, the junctions between the first transparent conductive wires 314 and the second transparent conductive wires 316 are separated by such as an insulator (not illustrated), so that the first transparent conductive wires 314 and the second transparent conductive wires 316 are electrically isolated at the junctions. Besides, the first transparent conductive wires 314 and the second transparent conductive wires 316 can also be completely separated by an insulation layer (not illustrated). The first transparent conductive wires 314 are disposed on the insulation layer, and the second transparent conductive wires 316 are disposed under the insulation layer electrically connected to the second contacts P2 via a plurality of conductive vias (not illustrated) passing through the insulation layer, wherein the second contacts P2 are disposed on the insulation layer and corresponding to the conductive vias,.

Referring to FIG. 2 and FIG. 3C. The transparent probe card 310 covers the wafer 300, and has a size slightly larger than or equal to that of the wafer 300. The first testing pads T1 (such as P-type electrodes) and the second testing pads T2 (such as N-type electrodes) disposed on each of the LED chips 302 are electrically connected via the first contacts P1 and the second contacts P2 disposed on the first transparent conductive wires 314 and the second transparent conductive wires 316 respectively. The first testing pads T1 are used for receiving a first voltage (such as a positive voltage), and the second testing pads T2 are used for receiving a second voltage (such as a negative voltage, a ground voltage, or other voltages lower than the first voltage). When the transparent probe card 310 electrifies the first testing pads T1 and the second testing pads T2 of each of the LED chips 302, the luminous layer of each of the LED chips 302 is powered on and illuminates so that a light-up test can be performed on the LED chips 302 disposed on the base substrate 304. Since the substrate and the conductive wires of the transparent probe card 310 are both made from transparent material, the transparent probe card 310, despite covering on the wafer 300, will not block the light signal L emitted from the LED chips 302, and the subsequent process of capturing the image formed by the light signal L emitted from the LED chips 302 will not be affected either.

In the present embodiment of the disclosure, a part or a totality of the first transparent conductive layer 314 and the second transparent conductive layer 316 disposed on the transparent probe card 310 can be selectively electrified, so that one or several rows of LED chips 302, and a part or a totality of the LED chips 302 distributed on the base substrate 304 can be sequentially or regionally powered to perform electric property test and light-up test via circuit control. For example, the LED chips 302 can be sequentially lighted up in a top down manner, meanwhile, the image of the LED chips 302 on the same row can be captured so as to obtain the optical field information and position information of each of the LED chips 302 on the same row.

In addition, the voltage-current supplied by the contacts P1 and P2 disposed on the transparent probe card 310 to perform electric property test can be controlled by an external auto testing equipment (ATE) to obtain the luminous intensity of each of the LED chips 302 and a voltage-current optical-electro characteristics curve. The values of the electric test (such as the working voltage and the reverse breakdown voltage) transmitted to the auto testing equipment via the test contacts P1 and P2 of the transparent probe card 310 can also be stored in the auto testing equipment and used as a basis for classifying the LED chips 302.

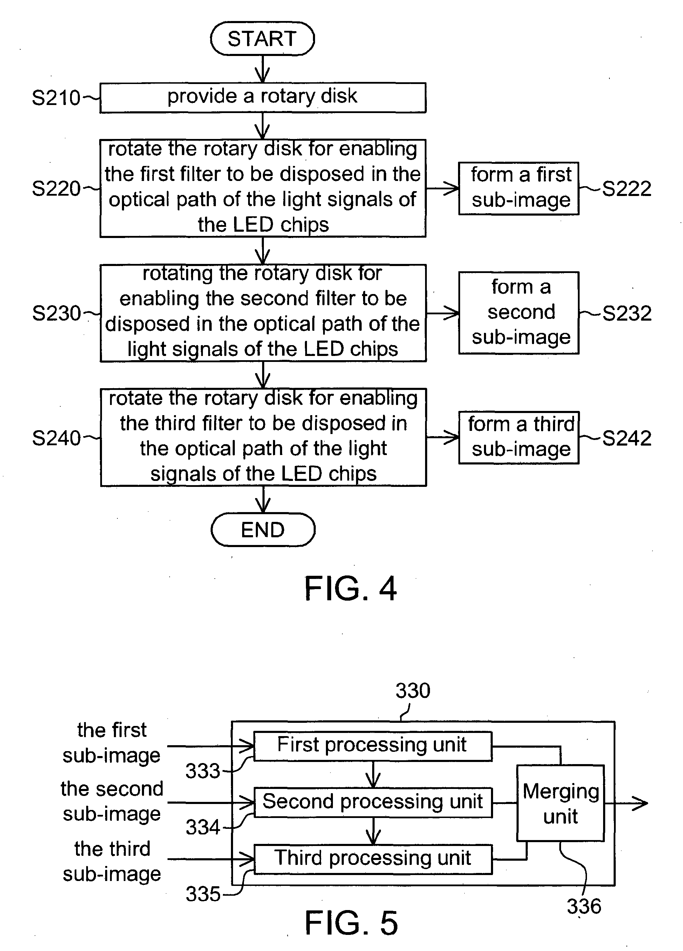

Referring to FIG. 2 and FIG. 4. FIG. 4 shows a flowchart of light filtering process according to an embodiment of the disclosure. In step S21 0, a rotary disk 362 is provided, wherein a first filter F1, a second filter F2 and a third filter F3 are respectively disposed on the peripheral region of the rotary disk 362, and rotate around of the center of the rotary disk 362 and change their positions accordingly. Next, in steps S220 and S222, the rotary disk 362 is rotated for enabling the first filter F1 to be disposed on the optical path of the light signal L of the LED chips 302 to form a first sub-image on the sensing element 332. The first filter F1, such as a red light filter, can filter off the light of all range of wavelengths except the red light wavelength, so that the first sub-image only corresponds to the red light component of the light signal L. Then, in steps S230 and S232, the rotary disk 362 is again rotated for enabling the second filter F2 to be disposed on the optical path of the light signals L of the LED chips 302 to form a second sub-image on the sensing element 332. The second filter F2, such as a green light filter, can filter off the light of all range of wavelengths except the green light wavelength, so that the second sub-image only corresponds to the green light component of the light signal L. In steps S240 and S242, the rotary disk 362 is again rotated for enabling the third filter F3 to be disposed on the optical path of the light signals L of the LED chips 302 to form a third sub-image on the sensing element 332. The third filter F3, such as a blue light filter, can filter off the light of all range of wavelengths except the blue light wavelength, so that the third sub-image only corresponds to the blue light component of the light signal L.

Referring to FIG. 5, an image processing module according to a embodiment of the disclosure is shown. The image processing module 330, such as a high-end computing image processor, includes a first processing unit 333, a second processing unit 334, a third processing unit 335 and a merging unit 336. The merging unit 336 is electrically connected to the first processing unit 333, the second processing unit 334 and the third processing unit 335. The first processing unit 333 is used for processing the first sub-image and converting the signal of the first sub-image into a first color light information corresponding to each of the LED chips 302. The first color light information includes such as the information of the spectrum and luminous intensity of the red light. The second processing unit 334 is used for processing the second sub-image and converting the signal of the second sub-image into a second color light information corresponding to each of the LED chips 302. The second color light information includes such as the information of the spectrum and luminous intensity of the green light. The third processing unit 335 is used for processing the third sub-image and converting the signal of the third sub-image into a third color light information corresponding to each of the LED chips 302. The third color light information includes such as the information of the spectrum and luminous intensity of the blue light. The merging unit 336 is used for merging the first, the second and the third color light information to reproduce the optical field information corresponding to all of the spectrums of the visible lights and the luminous intensities of the visible lights of each of the LED chips 302.

According to the detection method and detection device for wafer level LED chips and the transparent probe card thereof disclosed in the above embodiments of the disclosure, the LED chips disposed on the base substrate are lighted up by the transparent probe card, and a light-up test is performed on a part or all of the LED chips. When the LED chips are lighted up, the imaging process is performed by the imaging module and the image processing module for one or several times, so that all of the optical field information and position information of the LED chips can be obtained at one time. The conventional point testing device can only detect one single LED chip at a time. Afterwards, the spectrum and luminous intensity of each of the LED chips are obtained by the analysis module for performing classification. Thus, the detection method and detection device for wafer level LED chips and the transparent probe card thereof disclosed in the disclosure not only meet the market requirements of fast response rate, excellent reproducibility, high light sensitivity and simple detection system, but also have the advantages of quick detection and classification.

While the disclosure has been described by way of example and in terms of the exemplary embodiment(s), it is to be understood that the disclosure is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A detection method for wafer level LED chips (302), wherein a wafer (300) comprises a base substrate (304) and a plurality of LED chips (302) disposed on the base substrate, each of the LED chips (302) comprises at least a testing pad (T1, T2), the detection method comprising:
providing a transparent probe card (310) comprising a plurality of contacts (P1, P2) corresponding to the testing pads (T1, T2);
covering the wafer with the transparent probe card (310);
**characterized by**
electrically connecting the testing pads (T1, T2) via the contacts of the transparent probe card (310) so as to perform a light-up test on the LED chips (302);
performing an imaging process on light signals of the LED chips (302) when the LED chips (302) are lighted up so to form an image on a sensing element (332);
performing a light filtering process, which comprises:
providing a rotary disk (362) on which a first filter (F1), a second filter (F2) and a third filter (F3) are disposed;
rotating the rotary disk (362) for enabling the first filter (F1) to be disposed in an optical path of the light signals of the LED chips to form a first sub-image on the sensing element (332);
rotating the rotary disk (362) for enabling the second filter (F2) to be disposed in the optical path of the light signals of the LED chips to form a second sub-image on the sensing element (332); and
rotating the rotary disk (362) for enabling the third filter (F3) to be disposed in the optical path of the light signals of the LED chips to form a third sub-image on the sensing element (332);
capturing the image and converting the image into an optical field information and a position information corresponding to each of the LED chips (302);
obtaining a spectrum and luminous intensity of each of the LED chips (302) according to the optical field information of each of the LED chips (302); and
classifying the LED chips (302) according to the spectrum and/or luminous intensity of each of the LED chips (302).

2. The detection method according to claim 1, wherein after the light filtering process, the method further comprises:
capturing the first sub-image and converting the first sub-image into a first color light information corresponding to each of the LED chips (302);
capturing the second sub-image and converting the second sub-image into a second color light information corresponding to each of the LED chips (302);
capturing the third sub-image and converting the third sub-image into a third color light information corresponding to each of the LED chips (302); and
merging the first, the second and the third color light information to obtain the optical field information corresponding to each of the LED chips (302).

3. The detection method according to claim 2 wherein the first color light information comprises information of the spectrum and luminous intensity of a red light, the second color light information comprises information of the spectrum and luminous intensity of a green light, the third color light information comprises information of the spectrum and luminous intensity of a blue light.

4. A detection device for wafer level LED chips, wherein the detection device is suitable for a wafer (300) which comprises a base substrate (304) and a plurality of the LED chips (302) disposed on the base substrate (304) and comprising a plurality of testing pads (T1, T2), the detection device comprising:
a transparent probe card (310) comprising a plurality of contacts (P1, P2) respectively corresponding to the testing pads (T1, T2) and for covering the wafer;
**characterized in that**
the transparent probe card (310) is suitable for electrically connecting the testing pads (T1, T2) via the contacts (P1, P2) of the transparent probe card (310) so as to perform a light-up test on the LED chips (302); and **in that** the detection device further comprises an imaging module (320) for collecting light signals after lighting up the LED chips (302) to form an image;
an image processing module (330) for capturing the image and converting the image into an optical field information and a position information corresponding to each of the LED chips (302);
an analysis module (340) coupled to the image processing module (330), wherein the analysis module obtains a spectrum and luminous intensity of each of the LED chips according to the optical field information and the position information of each of the LED chips (302);
a classification module (350) for coupling the analysis module and the image processing module to obtain the position information of each of the LED chips (302) and classifying the LED chips (302) according to the spectrum and/or luminous intensity of each of the LED chips (302); and
a filter module (360) for filtering the light signals of the LED chips (302), wherein the image processing module (330) comprises a sensing element (332), and the filter module (360) comprises:
a rotary disk (362);
a first filter (F1) disposed on the rotary disk (362), wherein the first filter is rotatable to an optical path of the light signals of the LED chips (302) along with the rotary disk to form a first sub-image on the sensing element (332);
a second filter (F2) disposed on the rotary disk (362), wherein the second filter is rotatable to the optical path of the light signal of the LED chips (302) along with the rotary disk to form a second sub-image on the sensing element (332); and
a third filter (F3) disposed on the rotary disk (362), wherein the third filter is rotatable to the optical path of the light signal of the LED chips (302) along with the rotary disk to form a third sub-image on the sensing element (332).

5. The detection device according to claim 4, wherein the image processing module (330) further comprises:
a first processing unit (333) for processing the first sub-image and converting the first sub-image into a first color light information corresponding to each of the LED chips (302);
a second processing unit (334) for processing the second sub-image and converting the second sub-image into a second color light information corresponding to each of the LED chips (302);
a third processing unit (335) for processing the third sub-image and converting the third sub-image into a third color light information corresponding to each of the LED chips (302); and
a merging unit (336) electrically connected to the first, the second and the third processing units (333, 334, 335) for merging the first, the second and the third color light information to reproduce the optical field information corresponding to each of the LED chips (302).

6. The detection device according to claim 5, wherein the first color light information comprises information of the spectrum and luminous intensity of a red light, the second color light information comprises information of the spectrum and luminous intensity of a green light, the third color light information comprises information of the spectrum and luminous intensity of a blue light.

7. The detection device according to claim 4, wherein the wafer (300) comprises a base substrate (304) and a plurality of the LED chips (302) disposed on the base substrate (304), wherein each of the LED chips (302) comprises a plurality of first testing pads (T1) and a plurality of second testing pads (T2), the transparent probe card further comprising:
a transparent substrate (312);
a plurality of first transparent conductive wires (314) disposed on the transparent substrate (312), wherein each of the first transparent conductive wires (314) comprises a plurality of first contacts (P1) whose positions corresponding to that of the first testing pads (T1); and
a plurality of second transparent conductive wires (316) disposed on the transparent substrate and intersected and electrically isolated with the first transparent conductive wires (314), wherein each of the second transparent conductive wires (316) comprises a plurality of second contacts (P2) whose positions corresponding to that of the second testing pads (T2).

8. The detection device according to claim 7, wherein a material of the transparent substrate (312) comprises glass, and a material of the first and the second transparent conductive wires (314, 316) comprises indium tin oxide.

9. The detection device according to claim 7, wherein the first and the second contacts (P1, P2) are conductive bumps.

10. The detection device according to claim 7, wherein the first transparent conductive wires (314) and the second transparent conductive wires (316) are substantially perpendicular to each other and respectively for receiving a first voltage and a second voltage different from the first voltage.

11. The detection device according to claim 7, wherein each of the first testing pads (T1) is electrically connected to its corresponding first contact (P1), and each of the second testing pads (T2) is electrically connected to its corresponding second contact (P2).

## Patentansprüche

1. Detektionsverfahren für LED-Chips (302) auf Wafer-Ebene, wobei ein Wafer (300) ein Basissubstrat (304) und mehrere auf dem Basissubstrat angeordnete LED-Chips (302) aufweist, wobei jeder der LED-Chips (302) mindestens ein Test-Pad (T1, T2) aufweist, wobei das Detektionsverfahren umfasst:
Bereitstellen einer transparenten Probe-Karte (310) mit mehreren Kontakten (P1, P2), die den Test-Pads (T1, T2) entsprechen;
Bedecken des Wafers mit der transparenten Probe-Karte (310);
**gekennzeichnet durch**
elektrisches Verbinden der Test-Pads (T1, T2) über die Kontakte der transparenten Probe-Karte (310) zum Durchführen eines Aufleucht-Tests an den LED-Chips (302);
Durchführen eines Bilderzeugungsvorgangs auf Lichtsignale der LED-Chips (302) hin, wenn die LED-Chips (302) zum Aufleuchten gebracht werden, um ein Bild auf einem Abtastelement (332) zu erzeugen;
Durchführen eines Lichtfiltervorgangs, der umfasst:
Bereitstellen einer Drehscheibe (362), an der ein erster Filter (F1), ein zweiter Filter (F2) und ein dritter Filter (F3) angeordnet sind;
Drehen der Drehscheibe (362) zum Ermöglichen des Anordnens des ersten Filters (F1) in einem Lichtweg der Lichtsignale der LED-Chips, um ein erstes Teilbild auf dem Abtastelement (332) zu erzeugen;
Drehen der Drehscheibe (362) zum Ermöglichen des Anordnens des zweiten Filters (F2) in dem Lichtweg der Lichtsignale der LED-Chips, um ein zweites Teilbild auf dem Abtastelement (332) zu erzeugen; und
Drehen der Drehscheibe (362) zum Ermöglichen des Anordnens des dritten Filters (F3) in dem Lichtweg der Lichtsignale der LED-Chips, um ein drittes Teilbild auf dem Abtastelement (332) zu erzeugen;
Erfassen des Bildes und Konvertieren des Bildes in eine Optikfeld-Information und eine Positions-Information in Entsprechung zu jedem der LED-Chips (302);
Erhalt eines Spektrums und einer Lichtintensität eines jeden der LED-Chips (302) entsprechend der Optikfeld-Information eines jeden der LED-Chips (302); und
Klassifizieren der LED-Chips (302) entsprechend dem Spektrum und/ oder der Lichtintensität eines jeden der LED-Chips (302).

2. Detektionsverfahren nach Anspruch 1, wobei das Verfahren im Anschluss an den Lichtfiltervorgang ferner umfasst:
Erfassen des ersten Teilbildes und Konvertieren des ersten Teilbildes in eine erste Farblicht-Information entsprechend einem jeden der LED-Chips (302);
Erfassen des zweiten Teilbildes und Konvertieren des zweiten Teilbildes in eine zweite Farblicht-Information entsprechend einem jeden der LED-Chips (302);
Erfassen des dritten Teilbildes und Konvertieren des dritten Teilbildes in eine dritte Farblicht-Information entsprechend einem jeden der LED-Chips (302); und
Zusammenführen der ersten, zweiten und dritten Farblicht-Information zum Erhalt der einem jedem der LED-Chips (302) entsprechenden Optikfeld-Information.

3. Detektionsverfahren nach Anspruch 2, bei dem die erste Farblicht-Information Information zu dem Spektrum und der Lichtintensität roten Lichts aufweist, die zweite Farblicht-Information Information zu dem Spektrum und der Lichtintensität grünen Lichts aufweist, und die dritte Farblicht-Information Information zu dem Spektrum und der Lichtintensität blauen Lichts aufweist.

4. Detektionsvorrichtung für LED-Chips auf Wafer-Ebene, wobei die Detektionsvorrichtung geeignet ist für einen Wafer (300), der ein Basissubstrat (304) und mehrere LED-Chips (302) aufweist, die auf dem Basissubstrat (304) angeordnet sind und mehrere Test-Pads (T1, T2) aufweisen, wobei die Detektionsvorrichtung umfasst:
eine transparente Probe-Karte (310), die mehrere Kontakte (P1, P2), aufweist, welche jeweils den Test-Pads (T1, T2) entsprechen, und die zum Bedecken des Wafers vorgesehen ist;
**dadurch gekennzeichnet, dass**
die transparente Probe-Karte (310) zum elektrischen Verbinden der Test-Pads (T1, T2) über die Kontakte (P1, P2) der transparenten Probe-Karte (310) geeignet ist, um einen Aufleucht-Test an den LED-Chips (302) durchzuführen; und dass die Detektionsvorrichtung ferner ein Bilderzeugungsmodul (320) aufweist, das nach dem Aufleuchtenlassen der LED-Chips (302) Lichtsignale aufnimmt, um ein Bild zu erzeugen;
ein Bildverarbeitungsmodul (330) zum Erfassen des Bildes und Konvertieren des Bildes in eine Optikfeld-Information und eine Positions-Information in Entsprechung zu jedem der LED-Chips (302) vorgesehen ist;
ein Analysemodul (340) vorgesehen ist, das mit dem Bildverarbeitungsmodul (330) verbunden ist, wobei das Analysemodul ein Spektrum und eine Lichtintensität eines jeden der LED-Chips entsprechend der Optikfeld-Information und der Positions-Information eines jeden der LED-Chips (302) erstellt; und
ein Klassifizierungsmodul (350) vorgesehen ist, welches das Analysemodul und das Bildverarbeitungsmodul koppelt, um Positions-Information zu jedem der LED-Chips (302) zu erhalten und die LED-Chips (302) entsprechend dem Spektrum und/oder der Lichtintensität eines jeden der LED-Chips (302) zu klassifizieren; und
ein Filtermodul (360) zum Filtern der Lichtsignale der LED-Chips (302) vorgesehen ist, wobei das Bildverarbeitungsmodul (330) ein Abtastelement (332) aufweist, und wobei das Filtermodul (360) aufweist:
eine Drehscheibe (362);
einen ersten Filter (F1), der an der Drehscheibe (362) angeordnet ist,
wobei der erste Filter zusammen mit der Drehscheibe auf einen Lichtweg der Lichtsignale der LED-Chips (302) drehbar ist, um ein erstes Teilbild auf dem Abtastelement (332) zu erzeugen;
einen zweiten Filter (F2), der an der Drehscheibe (362) angeordnet ist,
wobei der zweite Filter zusammen mit der Drehscheibe auf den Lichtweg der Lichtsignale der LED-Chips (302) drehbar ist, um ein zweites Teilbild auf dem Abtastelement (332) zu erzeugen; und
einen dritten Filter (F3), der an der Drehscheibe (362) angeordnet ist, wobei der dritte Filter zusammen mit der Drehscheibe auf den Lichtweg der Lichtsignale der LED-Chips (302) drehbar ist, um ein drittes Teilbild auf dem Abtastelement (332) zu erzeugen.

5. Detektionsvorrichtung nach Anspruch 4, bei der das Bilderzeugungsmodul (330) ferner aufweist:
eine erste Verarbeitungseinheit (333) zum Verarbeiten des ersten Teilbildes und Konvertieren des ersten Teilbildes in eine erste Farblicht-Information entsprechend einem jeden der LED-Chips (302);
eine zweite Verarbeitungseinheit (334) zum Verarbeiten des zweiten Teilbildes und Konvertieren des zweiten Teilbildes in eine zweite Farblicht-Information entsprechend einem jeden der LED-Chips (302);
eine dritte Verarbeitungseinheit (335) zum Verarbeiten des dritten Teilbildes und Konvertieren des dritten Teilbildes in eine dritte Farblicht-Information entsprechend einem jeden der LED-Chips (302); und
eine Zusammenführungseinheit (336), die elektrisch mit den ersten, zweiten und dritten Verarbeitungseinheiten (333, 334, 335) verbunden ist, um die erste, die zweite und die dritte Farblicht-Information zwecks Wiedergabe der einem jedem der LED-Chips (302) entsprechenden Optikfeld-Information zusammenzuführen.

6. Detektionsvorrichtung nach Anspruch 5, bei der die erste Farblicht-Information Information zu dem Spektrum und der Lichtintensität roten Lichts aufweist, die zweite Farblicht-Information Information über das Spektrum und die Lichtintensität grünen Lichts aufweist, und die dritte Farblicht-Information Information über das Spektrum und die Lichtintensität blauen Lichts aufweist.

7. Detektionsvorrichtung nach Anspruch 4, bei der der Wafer (300) ein Basissubstrat (304) und mehrere auf dem Basissubstrat (304) angeordnete LED-Chips (302) aufweist, wobei jeder der LED-Chips (302) mindestens mehrere erste Test-Pads (T1) und mehrere zweite Test-Pads (T2) aufweist, wobei die transparente Probe-Karte ferner aufweist:
ein transparentes Substrat (312);
mehrere erste transparente Leiterdrähte (314), die auf dem transparenten Substrat (312) angeordnet sind, wobei jeder der ersten transparenten Leiterdrähte (314) mehrere erste Kontakte (P1) aufweist, deren Positionen denjenigen der ersten Test-Pads (T1) entsprechen; und
mehrere zweite transparente Leiterdrähte (316), die auf dem transparenten Substrat angeordnet sind und die ersten transparenten Leiterdrähte (314) schneiden und gegenüber diesen isoliert sind, wobei jeder der zweiten transparenten Leiterdrähte (316) mehrere zweite Kontakte (P2) aufweist, deren Positionen denjenigen der zweiten Test-Pads (T2) entsprechen.

8. Detektionsvorrichtung nach Anspruch 7, bei der ein Material des transparenten Substrats (312) Glas aufweist und ein Material der ersten und zweiten transparenten Leiterdrähte (314, 316) Indiumzinnoxid aufweist.

9. Detektionsvorrichtung nach Anspruch 7, bei der die ersten und die zweiten Kontakte (P1, P2) leitende Vorsprünge sind.

10. Detektionsvorrichtung nach Anspruch 7, bei der die ersten transparenten Leiterdrähte (314) und die zweiten transparenten Leiterdrähte (316) im Wesentlichen rechtwinklig zueinander verlaufen und eine erste Spannung bzw. eine sich von der ersten Spannung unterscheidende zweite Spannung erhalten.

11. Detektionsvorrichtung nach Anspruch 7, bei der jeder der ersten Test-Pads (T1) elektrisch mit seinem entsprechenden ersten Kontakt (P1) verbunden ist und jeder der zweiten Test-Pads (T2) elektrisch mit seinem entsprechenden zweiten Kontakt (P2) verbunden ist.

## Revendications

1. Procédé de détection pour puces DEL à l'état de tranche (302), dans lequel une tranche (300) comprend un substrat de base (304) et une pluralité de puces DEL (302) disposées sur le substrat de base, chacune des puces DEL (302) comprend au moins un plot de test (T1, T2), le procédé de détection comprenant :
la prévision d'une carte sonde transparente (310) comprenant une pluralité de contacts (P1, P2) correspondant aux plots de test (T1, T2) ;
la couverture de la tranche avec la carte sonde transparente (310) ;
**caractérisé par**
la connexion électrique des plots de test (T1, T2) via les contacts de la carte sonde transparente (310) de façon à effectuer un test d'allumage sur les puces DEL (302) ;
l'exécution d'un processus d'imagerie sur les signaux lumineux des puces DEL (302) lorsque les puces DEL (302) sont allumées de façon à former une image sur un élément de détection (332) ;
l'exécution d'un processus de filtrage de lumière, qui comprend :
la prévision d'un disque rotatif (362) sur lequel sont disposés un premier filtre (F1), un deuxième filtre (F2) et un troisième filtre (F3) ;
la rotation du disque rotatif (362) pour permettre au premier filtre (F1) d'être placé sur un chemin optique des signaux lumineux des puces DEL pour former une première sous-image sur l'élément de détection (332) ;
la rotation du disque rotatif (362) pour permettre au deuxième filtre (F2) d'être placé sur le chemin optique des signaux lumineux des puces DEL pour former une deuxième sous-image sur l'élément de détection (332) ; et
la rotation du disque rotatif (362) pour permettre au troisième filtre (F3) d'être placé sur le chemin optique des signaux lumineux des puces DEL pour former une troisième sous-image sur l'élément de détection (332) ;
la capture de l'image et la conversion de l'image en une information de champ optique et une information de position correspondant à chacune des puces DEL (302) ;
l'obtention d'un spectre et d'une intensité lumineuse de chacune des puces DEL (302) en fonction de l'information de champ optique de chacune des puces DEL (302) ; et
la classification des puces DEL (302) en fonction du spectre et/ou de l'intensité lumineuse de chacune des puces DEL (302).

2. Procédé de détection selon la revendication 1, dans lequel, après le processus de filtrage de lumière, le procédé comprend en outre :
la capture de la première sous-image et la conversion de la première sous-image en une information de lumière de première couleur correspondant à chacune des puces DEL (302) ;
la capture de la deuxième sous-image et la conversion de la deuxième sous-image en une information de lumière de deuxième couleur correspondant à chacune des puces DEL (302) ;
la capture de la troisième sous-image et la conversion de la troisième sous-image en une information de lumière de troisième couleur correspondant à chacune des puces DEL (302) ; et
la fusion des informations de lumières de première, deuxième et troisième couleurs pour obtenir les informations de champ optique correspondant à chacune des puces DEL (302).

3. Procédé de détection selon la revendication 2, dans lequel l'information de lumière de première couleur comprend des informations concernant le spectre et l'intensité lumineuse d'une lumière rouge, l'information de lumière de deuxième couleur comprend des informations concernant le spectre et l'intensité lumineuse d'une lumière verte, l'information de lumière de troisième couleur comprend des informations concernant le spectre et l'intensité lumineuse d'une lumière bleue.

4. Dispositif de détection pour puces DEL à l'état de tranche, dans lequel le dispositif de détection est approprié pour une tranche (300) qui comprend un substrat de base (304) et une pluralité de puces DEL (302) disposées sur le substrat de base (304) et comprenant une pluralité de plots de test (T1, T2), le dispositif de détection comprenant :
une carte sonde transparente (310) comprenant une pluralité de contacts (P1, P2) correspondant respectivement aux plots de test (T1, T2) et destinée à recouvrir la tranche ;
**caractérisé en ce que**
la carte sonde transparente (310) est appropriée pour connecter électriquement les plots de test (T1, T2) via les contacts (P1, P2) de la carte sonde transparente (310) de façon à effecteur un test d'allumage sur les puces DEL (302) ; et **en ce que** le dispositif de détection comprend en outre :
un module d'imagerie (320) pour collecter des signaux lumineux après l'allumage des puces DEL (302) pour former une image ;
un module de traitement d'image (330) pour capturer les images et convertir l'image en une information de champs optique et une information de position correspondant à chacune des puces DEL (302) ;
un module d'analyse (340) couplé au module de traitement d'image (330), dans lequel le module d'analyse obtient un spectre et une intensité lumineuse pour chacune des puces DEL en fonction de l'information de champ optique et de l'information de position de chacune des puces DEL (302) ;
un module de classification (350) pour coupler le module d'analyse et le module de traitement d'image pour obtenir les informations de position de chacune des puces DEL (302) et classifier les puces DEL (302) en fonction du spectre et/ou de l'intensité lumineuse de chacune des puces DEL (302) ; et
un module de filtrage (360) pour filtrer les signaux lumineux des puces DEL (302), dans lequel le module de traitement d'image (330) comprend un élément de détection (332), et le module de filtrage (360) comprend :
un disque rotatif (362) ;
un premier filtre (F1) disposé sur le disque rotatif (362), dans lequel le premier filtre peut être tourné vers un chemin optique des signaux lumineux des puces DEL (302), avec le disque rotatif, pour former une première sous-image sur l'élément de détection (332) ;
un deuxième filtre (F2) disposé sur le disque rotatif (362), dans lequel le deuxième filtre peut être tourné vers le chemin optique du signal lumineux des puces DEL (302), avec le disque rotatif, pour former une deuxième sous-image sur l'élément de détection (332) ; et
un troisième filtre (F3) disposé sur le disque rotatif (362), dans lequel le troisième filtre peut être tourné vers le chemin optique du signal lumineux des puces DEL (302), avec le disque rotatif, pour former une troisième sous-image sur l'élément de détection (332).

5. Dispositif de détection selon la revendication 4, dans lequel le module de traitement d'image (330) comprend en outre :
une première unité de traitement (333) pour traiter la première sous-image et convertir la première sous-image en une information de lumière de première couleur correspondant à chacune des puces DEL (302) ;
une deuxième unité de traitement (334) pour traiter la deuxième sous-image et convertir la deuxième sous-image en une information de lumière de deuxième couleur correspondant à chacune des puces DEL (302) ;
une troisième unité de traitement (335) pour traiter la troisième sous-image et convertir la troisième sous-image en une information de lumière de troisième couleur correspondant à chacune des puces DEL (302) ; et
une unité de fusion (336) connectée électriquement aux première, deuxième et troisième unités de traitement (333, 334, 335) pour fusionner les informations de lumières de première, deuxième et troisième couleurs pour reproduire l'information de champ optique correspondant à chacune des puces DEL (302).

6. Dispositif de détection selon la revendication 5, dans lequel l'information de lumière de première couleur comprend des informations concernant le spectre et l'intensité lumineuse d'une lumière rouge, l'information de lumière de deuxième couleur comprend des informations concernant le spectre et l'intensité lumineuse d'une lumière verte, l'information de lumière de troisième couleur comprend des informations concernant le spectre et l'intensité lumineuse d'une lumière bleue.

7. Dispositif de détection selon la revendication 4, dans lequel la galette (300) comprend un substrat de base (304) et une pluralité de puces DEL (302) disposées sur le substrat de base (304), où chacune des puces DEL (302) comprend une pluralité de premiers plots de test (T1) et une pluralité de deuxièmes plots de test (T2), la carte sonde transparente comprenant en outre :
un substrat transparent (312) ;
une pluralité de premiers fils conducteurs transparents (314) disposés sur le substrat transparent (312), où chacun des fils conducteurs transparents (314) comprend une pluralité de premiers contacts (P1) dont les positions correspondent à celles des premiers plots de test (T1) ; et
une pluralité de deuxièmes fils conducteurs transparents (316) disposés sur le substrat transparent, se croisant avec les premiers fils conducteurs transparents (314) et électriquement isolés de ceux-ci, où chacun des deuxièmes fils conducteurs transparents (316) comprend une pluralité de deuxièmes contacts (P2) dont les positions correspondent à celles des deuxièmes plots de test (T2).

8. Dispositif de détection selon la revendication 7, dans lequel un matériau du substrat transparent (312) comprend du verre, et un matériau des premiers et deuxièmes fils conducteurs transparents (314, 316) comprend de l'oxyde d'indium-étain.

9. Dispositif de détection selon la revendication 7, dans lequel les premiers et deuxièmes contacts (P1, P2) sont des bosses conductrices.

10. Dispositif de détection selon la revendication 7, dans lequel les premiers fils conducteurs transparents (314) et les deuxièmes fils conducteurs transparents (316) sont essentiellement perpendiculaires entre eux et sont respectivement destinés à recevoir une première tension et une deuxième tension différente de la première tension.

11. Dispositif de détection selon la revendication 7, dans lequel chacun des premiers plots de test (T1) est électriquement connecté à son premier contact correspondant (P1), et chacun des deuxièmes plots de test (T2) est électriquement connecté à son deuxième contact correspondant (P2).
